# FASCICULE DE BREVET EUROPEEN

(11) **EP 1 596 325 B1**
(45) Date de publication et mention de la délivrance du brevet: **17.08.2011**
(21) Numéro de dépôt: 05103900.6
(22) Date de dépôt: 10.05.2005
(51) Int. Cl.: G06K 19/077, G06K 7/00

(54) **Modulation de charge d'un transpondeur**
Ladungsmodulation eines Transponders
Charge modulation of a transponder

(30) Priorité: 14.05.2004 FR 0450950
(43) Date de publication de la demande: 16.11.2005
(73) Titulaire: STMICROELECTRONICS S.A., 92120 Montrouge (FR)
(72) Inventeur: Rizzo, Pierre Résidence Port Royal, 13100, Aix en Provence (FR); Moreaux, Christophe, 13510, Eguilles (FR)
(74) Mandataire: de Beaumont, Michel

(56) Documents cités:
- EP-A- 0 568 067
- WO-A-01/08088
- US-A- 6 122 492
- PATENT ABSTRACTS OF JAPAN vol. 1999, no. 04, 30 avril 1999 (1999-04-30) & JP 11 015934 A (NIPPON STEEL CORP), 22 janvier 1999 (1999-01-22)

## Description

La présente invention concerne le domaine des transpondeurs, et plus particulièrement celui des étiquettes et des cartes à puce sans contact, destinés à communiquer avec une borne de lecture-écriture par transmission de données radio fréquence.

L'invention s'applique plus particulièrement à des transpondeurs téléalimentés qui extraient l'énergie nécessaire à leur fonctionnement du champ électromagnétique rayonné par la borne dans le voisinage duquel ils se trouvent.

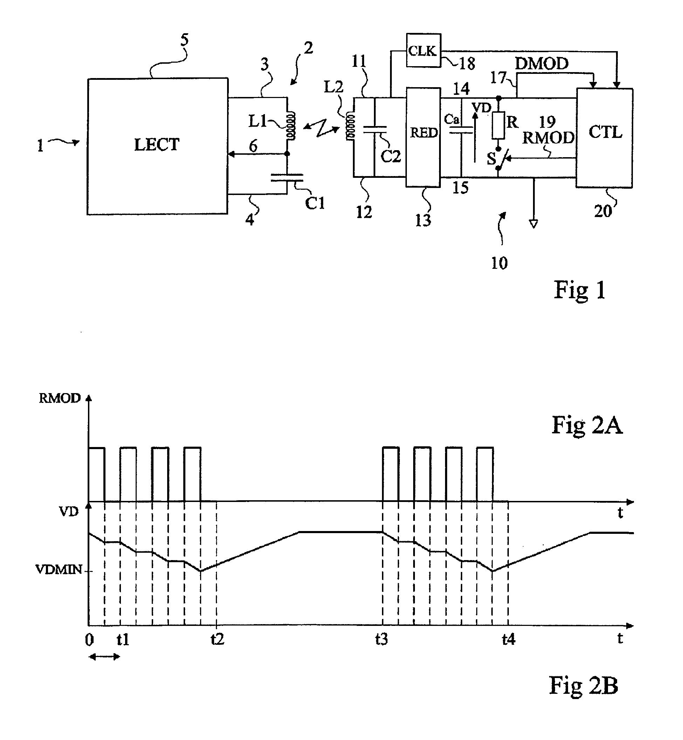

La figure 1 illustre, de façon très schématique et sous forme de blocs, une borne de lecture de transpondeur électromagnétique et un transpondeur devant communiquer avec cette borne.

Côté borne de lecture, on trouve généralement un circuit oscillant série 2 constitué d'une inductance L1 formant une antenne en série avec un condensateur C1 connecté entre une borne de sortie 3 d'un amplificateur ou coupleur d'antenne (non représenté) et une borne de référence 4 (généralement la masse). Généralement, une résistance (non représentée) est intercalée entre la sortie du coupleur d'antenne et l'inductance L1. Le coupleur d'antenne appartient à un ou plusieurs circuits 5 (LECT) de commande du circuit oscillant et d'exploitation des données reçues et comprend, entre autres, un modulateur-démodulateur et un microprocesseur pour traiter les signaux de commande et de données. Dans l'exemple de la figure 1, un noeud 6 d'interconnexion entre le condensateur C1 et l'inductance L1 constitue une borne de prélèvement du signal de données reçu du transpondeur 10 à destination du démodulateur de la borne 1.

Le circuit 5 de la borne communique généralement avec différents circuits d'entrée-sortie (clavier, écran, moyens de transmission vers un serveur central, etc.) et/ou circuits de traitement non représentés. Les circuits de la borne de lecture-écriture 1 extraient l'énergie nécessaire à leur fonctionnement d'un circuit d'alimentation (non représenté) connecté, par exemple, au réseau électrique ou à une batterie.

Côté transpondeur 10, une inductance L2, en parallèle avec un condensateur C2, forme un circuit oscillant parallèle (appelé circuit résonant), destiné à capter le champ électromagnétique engendré par le circuit oscillant série (L1, C1) de la borne 1. Le circuit résonant (L2, C2) du transpondeur 10 est accordé sur la fréquence de résonance du circuit oscillant L1C1 de la borne 1. Le circuit résonant parallèle L2C2 est destiné à capter le champ électromagnétique engendré par le circuit oscillant série L1C1 de la borne 1.

Les bornes 11, 12 du circuit résonant L2C2, correspondant aux bornes du condensateur C2, sont reliées à deux bornes d'entrée alternative d'un circuit 13 (RED) de redressement constitué, par exemple, d'un pont (non représenté) de quatre diodes pour un redressement double alternance. On notera que le circuit 13 peut être remplacé par un montage de redressement mono-alternance. Un condensateur Ca est connecté aux bornes de sortie redressée 14 et 15 du circuit 13 pour stocker l'énergie et lisser la tension de sortie redressée.

Lorsque le transpondeur 10 entre dans le champ électromagnétique de la borne 1, une tension haute fréquence est engendrée aux bornes du circuit résonant L2C2. Cette tension, redressée par le circuit 13 et lissée par le condensateur Ca, devient une tension d'alimentation (VD) sur la borne 14 destinée à des circuits électroniques 20 du transpondeur 10. La tension VD est généralement régulée par un régulateur de tension (non représenté). Les circuits 20 (CTL) comprennent généralement un microprocesseur, une mémoire, et un circuit de commande. Pour simplifier, on fera par la suite référence à un seul circuit 20 contenant tous ces éléments. Le transpondeur 10 est généralement synchronisé au moyen d'une horloge (CLK) extraite, par un bloc 18, du signal haute fréquence récupéré aux bornes du condensateur C2, avant redressement. Le circuit 20 contient un moyen de démodulation de signaux 17 (DMOD) provenant de la borne 1 et prélevés sur la borne 14. Pour transmettre des données du transpondeur 10 vers la borne 1, le circuit 20 commande un étage de modulation (appelée rétromodulation) du circuit résonant L2C2. Cet étage de modulation est généralement constitué d'un interrupteur électronique S et d'une résistance R, en série entre les bornes 14 et 15. Le transistor S est commandé par des impulsions à une fréquence dite sous-porteuse (par exemple 424 kHz), inférieure à la fréquence du signal d'excitation du circuit oscillant L1C1 de la borne 1 (par exemple 13,56 MHz). Le circuit 20 fournit un signal de sortie 19 (RMOD) de commande par impulsions de l'interrupteur S. L'ensemble du circuit 20 et de l'étage de rétromodulation constituent une charge variable du transpondeur, équivalente à une résistance ramenée en parallèle sur le condensateur Ca. On désignera par la suite par Req, cette résistance équivalente.

Quand l'interrupteur S est fermé, le circuit oscillant du transpondeur est soumis à un amortissement supplémentaire par rapport à la charge constituée par le circuit 20, de sorte que le transpondeur prélève une quantité d'énergie plus importante du champ électromagnétique haute fréquence. Par conséquent, la variation d'énergie du transpondeur 10 se traduit, côté borne 1, par une variation d'amplitude et de phase du courant dans l'antenne L1. Cette variation est détectée dans le signal présent sur le noeud 6 et destinée au démodulateur de la borne 1. Les circuits oscillants de la borne 1 et du transpondeur 10 sont généralement accordés sur la fréquence de la porteuse, c'est-à-dire que leur fréquence de résonance est réglée sur la fréquence de 13,56 MHz. Généralement, tous les circuits électroniques du transpondeur 10 sont intégrés dans une même puce.

Les figures 2A et 2B illustrent, sous forme de chronogrammes, un exemple classique de fonctionnement du transpondeur 10 lors d'une transmission de données vers la borne 1. La figure 2A représente un exemple d'allure du signal RMOD de commande de l'interrupteur S fourni par le circuit 20 à une fréquence de sous-porteuse de période (T). Dans cet exemple, les données sont codées par des trains de quatre impulsions. D'autres formes de codage sont possibles. Généralement, le rapport cyclique de conduction de l'interrupteur S est fixé à 0,5.

La figure 2B illustre l'allure de la tension redressée VD présente sur la borne 14. Chaque mise en conduction de l'interrupteur S constitue une charge supplémentaire prélevée sur la réserve d'énergie stockée dans le condensateur Ca. La résistance R de rétromodulation est choisie pour provoquer une variation d'énergie du transpondeur 10 telle que la variation d'amplitude et de phase du courant résultante dans l'antenne L1 soit exploitable par le circuit 5 de la borne 1. Généralement, le courant de consommation interne du transpondeur 10 augmente dès que l'interrupteur S, par sa mise en conduction, vient réduire la résistance équivalente Req dans un rapport de trois à six. Cette augmentation de la consommation en courant entraîne une diminution de la tension VD.

A l'inverse, chaque ouverture de l'interrupteur S entraîne une augmentation de la tension VD jusqu'à la prochaine remise en conduction de l'interrupteur S. Dans l'exemple de la figure 2B, le rapport de variation de la résistance Req et donc du courant de consommation interne du transpondeur a été choisi proche de trois. Ainsi, la tension VD diminue globalement trois fois plus vite pendant les temps de conduction de l'interrupteur S qu'elle n'augmente pendant ses ouvertures. Cet affaiblissement de la tension VD est d'autant plus important que le transpondeur 10 est faiblement couplé avec la borne 1, c'est-à-dire quand les antennes sont distantes l'une de l'autre (de plus de soixante centimètres). Il en découle que le régulateur n'est plus à même de fournir une tension d'alimentation suffisante au circuit 10. En figure 2B, on a désigné VDMIN, le seuil minimal de tension VD en deçà duquel le régulateur « décroche » et le circuit 10 n'est plus alimenté. Dans l'exemple de la figure 2B, on suppose que la tension VD atteint la valeur minimale VDMIN à la fin d'un train de quatre impulsions.

Un problème qui se pose lorsque les circuits oscillants du transpondeur et de la borne sont distants est que l'énergie prélevée par le circuit de rétromodulation est telle que la tension d'alimentation du transpondeur est diminuée au point que ses circuits internes s'arrêtent de fonctionner correctement. Ceci a pour effet, d'une part, d'arrêter la transmission de données du transpondeur vers la borne et, d'autre part, de réduire la distance de téléalimentation du transpondeur.

Un autre problème est que, pour démoduler correctement le signal reçu, on doit prévoir un lecteur suffisamment sensible pour fonctionner alors que la tension VD est proche de VDMIN. Il en découle un risque de saturation du démodulateur lorsque, à l'inverse, la tension VD est plus élevée, c'est-à-dire quand le transpondeur est très proche du lecteur.

La présente invention vise à proposer une nouvelle solution qui pallie les inconvénients des solutions classiques, notamment lorsqu'un transpondeur se trouve en relation de couplage lointain ou proche avec une borne de lecture-écriture.

En relation de couplage lointain, l'invention vise à minimiser l'effet de diminution de la tension d'alimentation lié à la distance entre le transpondeur et la borne de lecture.

En relation de couplage proche, l'invention vise à minimiser les perturbations des circuits de démodulation de la borne liées à la distance entre le transpondeur et la borne de lecture.

La présente invention vise en outre à proposer une solution qui ne nécessite aucune modification structurelle du transpondeur.

Pour atteindre ces objets ainsi que d'autres, la présente invention prévoit un procédé de commande par trains d'impulsions d'un interrupteur de modulation de la charge d'un transpondeur dans un champ électromagnétique dont il extrait son alimentation, le rapport cyclique des impulsions étant asservi en fonction de la tension d'alimentation du transpondeur.

Selon un mode de mise en oeuvre de la présente invention, l'asservissement est linéaire.

Selon un mode de mise en oeuvre de la présente invention, l'asservissement est par paliers.

Selon un mode de mise en oeuvre de la présente invention, ladite tension d'alimentation est comparée à au moins une tension minimale.

Selon un mode de mise en oeuvre de la présente invention, ladite tension d'alimentation est comparée à au moins une tension maximale.

La présente invention prévoit également un transpondeur comprenant un circuit résonant dont il extrait sa tension d'alimentation à partir d'un champ électromagnétique rayonné par une borne, un circuit de modulation par trains d'impulsions dont au moins un interrupteur module la charge qu'il constitue sur le champ électromagnétique, et des moyens pour asservir le rapport cyclique des impulsions en fonction de ladite tension d'alimentation.

Selon un mode de réalisation de la présente invention, les moyens d'asservissement sont linéaires.

Selon un mode de réalisation de la présente invention, les moyens d'asservissement sont numériques.

Selon un mode de réalisation de la présente invention, le rapport cyclique est conditionné par une comparaison de ladite tension d'alimentation par rapport à une tension minimale.

Selon un mode de réalisation de la présente invention, le rapport cyclique est conditionné par une comparaison de ladite tension d'alimentation par rapport à une tension maximale.

Ces objets, caractéristiques et avantages, ainsi que d'autres de la présente invention seront exposés en détail dans la description suivante de modes de mise en oeuvre et de réalisation particuliers faite à titre non-limitatif en relation avec les figures jointes parmi lesquelles :
les figures 1, 2A et 2B qui ont été décrites précédemment sont destinées à exposer l'état de la technique et le problème posé ;
la figure 3 représente, de façon très schématique et sous forme de blocs, un premier mode de mise en oeuvre du procédé de commande d'interrupteur selon l'invention ;
les figures 4A à 4G illustrent sous forme de chronogrammes le fonctionnement du transpondeur selon la figure 3 ; et
la figure 5 représente sous forme de portes logiques un mode de réalisation de la fonction d'asservissement de la commande d'interrupteur selon l'invention.

Les mêmes éléments ont été désignés par les mêmes références aux différentes figures. Par souci de clarté, seuls les éléments nécessaires à la compréhension de l'invention ont été représentés aux figures et seront décrits par la suite. En particulier, les circuits électroniques numériques n'ont pas été détaillés du côté lecteur.

Une caractéristique de la présente invention est d'asservir le rapport cyclique des impulsions de commande d'un interrupteur de modulation d'un transpondeur à son alimentation.

De préférence, le rapport cyclique est obtenu à partir d'une comparaison de la tension d'alimentation par rapport à au moins un seuil.

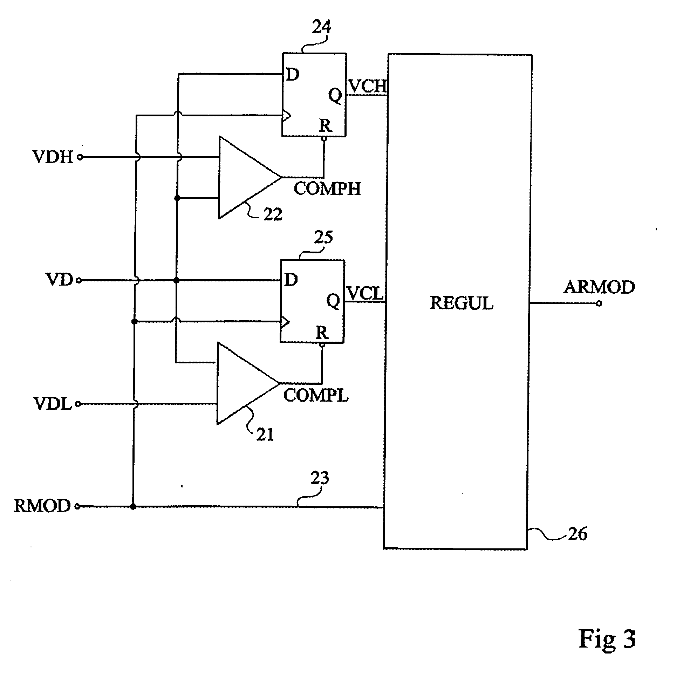

La figure 3 représente de façon schématique un mode de réalisation d'un circuit d'asservissement du signal de commande d'un interrupteur de rétromodulation mettant en oeuvre le procédé de commande par trains d'impulsions selon la présente invention. Pour simplifier, le reste des circuits du transpondeur n'a pas été représenté, et est classique.

Dans cet exemple, un train d'impulsions RMOD fourni par le circuit de commande 20 (figure 1), est appliqué sur une première entrée 23 d'un circuit d'asservissement 26 (REGUL) de la largeur des impulsions commandant la conduction de l'interrupteur S (figure 1) . Le circuit 26 qui est en pratique inclus dans le circuit 20 fournit un signal ARMOD. Généralement, le rapport cyclique du signal RMOD est fixé à 0,5.

La tension VD d'alimentation du circuit 20 est appliquée à des premières bornes d'entrée respectives d'un comparateur 21 et d'un comparateur 22. Le train d'impulsions RMOD est appliqué sur des entrées de synchronisation des bascules 24 et 25 de type D. Les sorties des bascules 24 et 25 constituent des entrées respectivement VCH et VCL du circuit 26. Les sorties COMPL et COMPH des comparateurs 21 et 22 sont appliquées sur des entrées inverseuses de remise à zéro R, respectivement des bascules 25 et 24. La tension VD est appliquée à chacune des entrées de chargement D des bascules 24 et 25. A chaque front montant du signal RMOD, la tension VD est chargée respectivement sur les sorties VCH et VCL pour les comparateurs 22 et 21.

Une première référence de tension VDL dite limite "basse" et une deuxième référence de tension VDH dite limite "haute", sont appliquées respectivement aux deuxièmes bornes d'entrée des comparateurs 21 et 22. La limite basse de tension VDL est choisie supérieure à la tension minimale de fonctionnement VDMIN du transpondeur 10. La limite haute VDH correspond à un seuil à partir duquel le niveau de la rétromodulation perturbe (sature) les circuits de démodulation de la borne 1, lors de la lecture des données transmises par le transpondeur 10. Un niveau bas du signal COMPL provoque la remise à zéro de la bascule 25. De la même manière, un niveau bas du signal COMPH provoque la remise à zéro de la bascule 24.
Le circuit 26 fournit en sortie un signal (ARMOD) de commande de l'interrupteur S dont le rapport cyclique de conduction est asservi en fonction de la tension VD. De préférence, le signal ARMOD est actif à l'état haut et commande la grille de l'interrupteur S (généralement un transistor de type MOS).

Dès que la tension VD atteint une des deux limites, basse VDL ou haute VDH, les signaux VCL ou VCH fournis par les bascules 25 ou 24 au circuit 26 entraînent, respectivement, une réduction ou une augmentation du rapport cyclique du signal RMOD. En sortie du circuit 26, le rapport cyclique du signal ARMOD est, soit réduit en deçà, soit augmenté au delà, de sa valeur en fonctionnement nominal, c'est-à-dire sans franchissement des limites VDL ou VDH. Il en découle que l'ouverture de l'interrupteur S est, soit avancée en cas de franchissement de la limite basse VDL, soit retardée en cas de franchissement de la limite haute VDH.

De préférence, la plage de variation du rapport cyclique est limitée par deux seuils haut et bas. Le seuil est choisi en fonction du seuil de conduction de l'interrupteur S en deçà duquel le lecteur 1 n'arrive plus à démoduler correctement les données transmises par le transpondeur 10. Généralement, ce seuil bas est choisi dans une plage de rapports cycliques de 0,1 à 0,4. De manière symétrique, le seuil haut est choisi en fonction du seuil haut de conduction de l'interrupteur S au delà duquel le lecteur 1 n'arrive plus à démoduler correctement les données transmises par le transpondeur 10. Typiquement, ce seuil haut est choisi dans une plage de rapports cycliques de 0,6 à 0, 9.

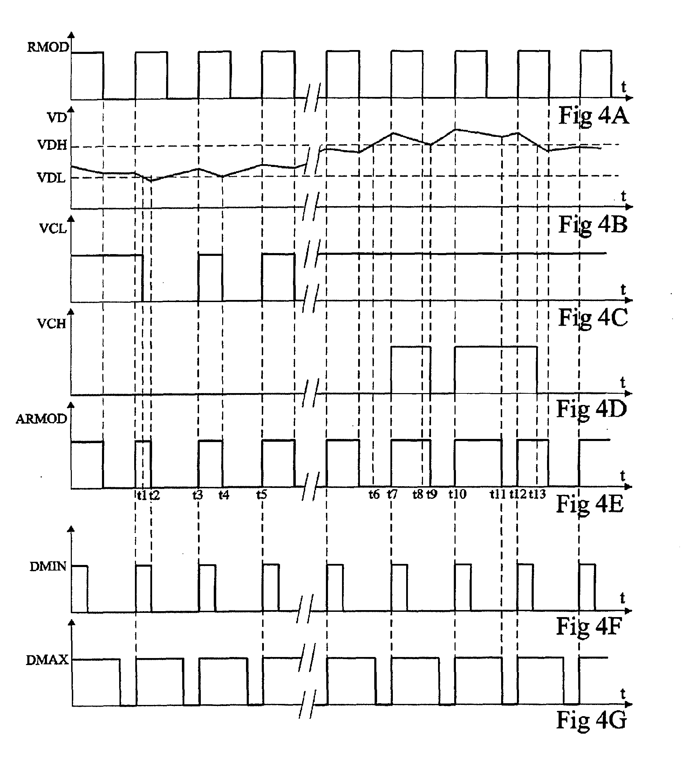

Les figures 4A à 4G illustrent, sous forme de chronogrammes, un exemple d'allure de signaux caractéristiques à différents points du mode de réalisation décrit dans la figure 3. Les figures 4A à 4E représentent respectivement les signaux de modulation RMOD, de la tension VD, de comparaison basse VCL et haute VCH, et du signal ARMOD de commande de l'interrupteur S. Ces chronogrammes représentent, en partie gauche, un asservissement du rapport cyclique de conduction de l'interrupteur S résultant d'un franchissement de la limite basse VDL, et en partie droite, un asservissement résultant d'un franchissement de la limite haute VDH.

Pour un fonctionnement nominal sans franchissement d'une des limites VDL ou VDH, le rapport cyclique du signal RMOD a été fixé à 0,5. A titre d'exemple, des seuils DMIN et DMAX limitant la plage de rapport cyclique par des durées minimale et maximale d'impulsions, ont été respectivement fixés à 0,25 et 0,75. Ces seuils ont été illustrés par deux chronogrammes supplémentaires (figures 4F et 4G) qui ne sont là que pour des raisons d'explication. En pratique, l'application de ces seuils ne nécessitera pas de génération de trames d'impulsions particulières.

Dans un fonctionnement avec franchissement de la limite basse VDL, supposons qu'à un instant t1 pendant une phase de conduction de l'interrupteur S, la tension VD atteigne la limite basse VDL. A cet instant t1, la sortie VCL de la bascule 25 commute vers un état bas. En supposant que l'instant t1 est en deçà de la durée minimale d'une impulsion, le circuit 26 maintient le signal ARMOD à l'état haut. A un instant t2, correspondant à la fin de la durée minimale d'une impulsion, le signal ARMOD bascule et commande l'ouverture de l'interrupteur S. L'ouverture de l'interrupteur S à l'instant t2 réduit la consommation du transpondeur provoquant une augmentation de la tension VD jusqu'à un instant t3. L'instant t3 correspond à la mise en conduction suivante de l'interrupteur S déclenchée par le circuit 26 au front montant du signal d'entrée RMOD. On suppose qu'à un instant t4, la tension VD atteint à nouveau la limite basse VDL provoquant l'ouverture prématurée de l'interrupteur S. Ici, l'instant t4 est postérieur à la durée minimale d'une impulsion fixée par le seuil DMIN, ce qui explique le basculement immédiat du signal ARMOD. A partir d'un instant t5 correspondant à la mise en conduction suivante, l'interrupteur S est de nouveau fermé. Ici, le seuil VDL n'est pas franchi. Le rapport cyclique du signal ARMOD est donc à sa valeur de fonctionnement nominal (0,5 dans cet exemple).

On voit que le rapport cyclique du signal ARMOD est asservi linéairement par le circuit 26 sur la tension VD dès que celle-ci est inférieure à VDL tout en restant limitée au seuil minimal DMIN du rapport cyclique de conduction.

Dans un fonctionnement avec franchissement de la limite haute VDH, supposons qu'à un instant t6 pendant une phase d'ouverture de l'interrupteur S, la tension VD atteigne la limite haute VDH. A cet instant t6, la sortie VCH de la bascule 24 est encore à l'état bas. A un instant t7 correspondant au front montant suivant du signal RMOD, la sortie VCH de la bascule 24 commute vers un état haut. L'instant t7 correspond à la mise en conduction suivante de l'interrupteur S déclenchée par le circuit 26 au front montant du signal d'entrée RMOD. La durée nominale de l'impulsion commencée à l'instant t7 du signal RMOD prend fin à un instant t8. La mise en conduction de l'interrupteur S à l'instant t7 augmente la consommation du transpondeur provoquant une diminution de la tension VD jusqu'à un instant t9 pour lequel on suppose que la tension VD est à nouveau supérieure à la limite haute VDH. Comme l'instant t9 est antérieur à la durée maximale d'une impulsion fixée par le seuil DMAX, le basculement à l'état bas du signal ARMOD et l'ouverture de l'interrupteur S sont immédiats. A partir d'un instant t10 correspondant à la mise en conduction suivante, l'interrupteur S est de nouveau fermé. La mise en conduction de l'interrupteur S à l'instant t10 augmente la consommation du transpondeur provoquant une diminution de la tension VD jusqu'à un instant t11 pour lequel on suppose que la tension VD est supérieure à la limite haute VDH. Ici, l'instant t11 correspond à la durée maximale d'une impulsion fixée par le seuil DMAX, ce qui explique le basculement immédiat du signal ARMOD. A un instant t12 correspondant au front montant suivant du signal d'entrée RMOD, la mise en conduction de l'interrupteur S est déclenchée par le circuit 26. On suppose qu'à un instant t13, la tension VD atteint et passe en dessous de la limite haute VDH, provoquant le basculement à l'état bas de la tension VCH. En supposant que l'instant t13 est en deçà de la durée minimale d'une impulsion, le circuit 26 maintient le signal ARMOD à l'état haut jusqu'à la fin de la durée nominale de l'impulsion RMOD. Le rapport cyclique du signal ARMOD est donc à sa valeur de fonctionnement nominale (0,5 dans cet exemple).

On voit que le rapport cyclique du signal ARMOD est asservi linéairement par le circuit 26 sur la tension VD dès que celle-ci est supérieure à VDH, tout en restant limité au seuil maximal DMAX du rapport cyclique de conduction.

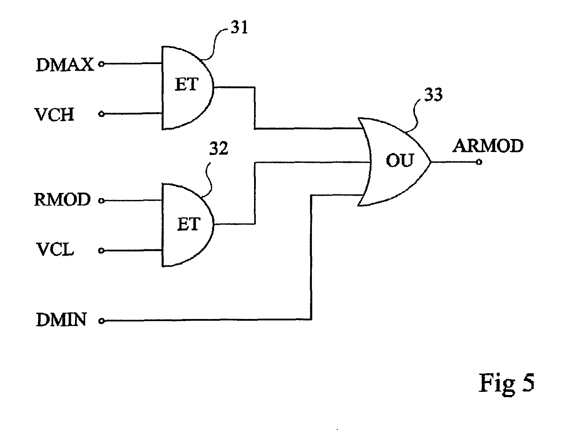

La figure 5 représente, sous forme de portes logiques, un mode de réalisation du circuit d'asservissement 26 (figure 3) du signal RMOD. Une première porte 31 de type ET reçoit sur ses deux entrées les signaux DMAX et VCH. Une deuxième porte 32 également de type ET, reçoit sur ses deux entrées les signaux RMOD et VCL. Le signal DMIN et les signaux de sortie des portes 31 et 32 sont appliqués sur trois entrées d'une porte 33 de type OU. La sortie de la porte 33 correspond au signal d'asservissement ARMOD du circuit 26 de la figure 3.

On pourra également prévoir un mode de réalisation numérique dans lequel les moyens d'asservissement sont constitués par des paliers de rapport cyclique. Ces paliers sont organisés sous forme d'une table stockée en mémoire non volatile (non représentée) du transpondeur 10 de la figure 1. En entrée, la table est constituée de paliers bornés par une valeur basse et haute de la tension VD. Chaque borne haute d'un palier correspond à la borne basse du palier directement supérieur en tension VD. Les bornes basse et haute des paliers situés aux extrémités de la plage d'excursion de la tension VD correspondent respectivement aux tensions VDL et VDH du premier mode de réalisation décrit dans la figure 3. En pratique, on suppose que la tension VD est d'abord mesurée sous forme analogique, et ensuite convertie sous forme numérique par tout moyen connu de conversion analogique-numérique. En sortie, la table fournit un rapport cyclique constant pour toutes les tensions VD comprises entre les bornes basse et haute d'un même palier. Les rapports cycliques des paliers extrêmes de la plage d'excursion de la tension VD correspondent respectivement aux seuils minimal DMIN et maximal DMAX du premier mode de réalisation décrit dans la figure 3. La résolution de l'asservissement dépend du nombre de paliers choisis pour couvrir la plage d'excursion de la tension VD, et de la granularité avec laquelle la conversion numérique du signal analogique VD est réalisée.

Un avantage de la présente invention est qu'elle réduit l'énergie prélevée par le circuit de rétromodulation du transpondeur en relation de couplage lointain. Ceci a pour effet d'augmenter la distance de téléalimentation.

Un autre avantage de la présente invention est qu'elle améliore la démodulation par la borne de lecture des données transmises par transpondeur, à la fois en couplage lointain et en couplage proche. La présente invention permet d'augmenter la sensibilité du lecteur en couplage lointain tout en réduisant fortement le risque de saturation du démodulateur du lecteur en couplage proche.

Bien que l'invention soit décrite en relation avec la tension d'alimentation, on pourra prévoir d'asservir le rapport cyclique en fonction de toute autre information ou signal lié à cette tension d'alimentation.

Bien entendu, la présente invention est susceptible de diverses variantes et modifications qui apparaîtront à l'homme de l'art. En particulier, les dimensionnements des limites basse et haute de la tension d'alimentation du transpondeur, ainsi que des seuils minimal et maximal de rapport cycliques dépendent de l'application et, notamment de la fréquence des différentes porteuses et de la portée du système.

## Revendications

1. Procédé de commande par trains d'impulsions d'un interrupteur (S) de modulation de la charge d'un transpondeur (10) dans un champ électromagnétique dont il extrait son alimentation, **caractérisé en ce que** le rapport cyclique des impulsions est asservi en fonction de la tension (VD) d'alimentation du transpondeur.

2. Procédé selon la revendication 1, dans lequel l'asservissement est linéaire.

3. Procédé selon la revendication 1, dans lequel l'asservissement est par paliers.

4. Procédé selon les revendications 1 à 3, dans lequel ladite tension d'alimentation (VD) est comparée à au moins une tension minimale (VDL).

5. Procédé selon l'une quelconque des revendications 1 à 4, dans lequel ladite tension d'alimentation (VD) est comparée à au moins une tension maximale.

6. Transpondeur comprenant un circuit résonant dont il extrait sa tension d'alimentation à partir d'un champ électromagnétique rayonné par une borne, et un circuit de modulation par trains d'impulsions dont au moins un interrupteur (S) module la charge qu'il constitue sur le champ électromagnétique, **caractérisé en ce qu'**il comporte des moyens pour asservir le rapport cyclique des impulsions en fonction de ladite tension d'alimentation.

7. Transpondeur selon la revendication 6, dans lequel les moyens d'asservissement sont linéaires.

8. Transpondeur selon la revendication 6, dans lequel les moyens d'asservissement sont numériques.

9. Transpondeur selon les revendications 7 ou 8, dans lequel le rapport cyclique est conditionné par une comparaison de ladite tension d'alimentation par rapport à une tension minimale.

10. Transpondeur selon l'une quelconque des revendications 7 à 9, dans lequel le rapport cyclique est conditionné par une comparaison de ladite tension d'alimentation par rapport à partir d'une tension maximale.

## Claims

1. A method for controlling by pulse trains a switch (S) for modulating the load of a transponder (10) in an electromagnetic field from which it extracts its power supply, **characterized in that** the duty ratio of the pulses is controlled according to the transponder supply voltage (VD).

2. The method of claim 1, wherein the control is linear.

3. The method of claim 1, wherein the control is incremental.

4. The method of any of claims 1 to 3, wherein said supply voltage (VD) is compared with at least one minimum voltage (VDL).

5. The method of any of claims 1 to 4, wherein said supply voltage (VD) is compared with at least one maximum voltage.

6. A transponder comprising a resonant circuit from which it extracts its supply voltage from an electromagnetic circuit radiated by a terminal, a pulse train modulation circuit having at least one switch (S) modulating the load that it forms on the electromagnetic field, and comprising means for controlling the duty ratio of the pulses according to said supply voltage.

7. The transponder of claim 6, wherein the control means are linear.

8. The transponder of claim 6, wherein the control means are digital.

9. The transponder of claim 7 or 8, wherein the duty ratio is conditioned by a comparison of said supply voltage with a minimum voltage.

10. The transponder of any of claims 7 to 9, wherein the duty ratio is conditioned by a comparison of said supply voltage with a maximum voltage.

## Patentansprüche

1. Ein Verfahren zur Steuerung von Pulsfolgen eines Schalters (S) zum Modulieren der Last eines Transponders (10) in einem elektromagnetischen Feld, aus dem er seine Leistungsversorgung zieht, **dadurch gekennzeichnet, dass** das Duty- bzw. Tastverhältnis der Impulse entsprechend der Transponder-Versorgungsspannung (VD) gesteuert wird.

2. Verfahren nach Anspruch 1, wobei die Steuerung linear erfolgt.

3. Verfahren nach Anspruch 1, wobei die Steuerung inkremental erfolgt.

4. Verfahren nach einem der Ansprüche 1 bis 3, wobei die Versorgungsspannung (VD) mit mindestens einer Minimalspannung (VDL) verglichen wird.

5. Verfahren nach einem der Ansprüche 1 bis 4, wobei die Versorgungsspannung (VD) mit mindestens einer Maximalspannung verglichen wird.

6. Ein Transponder, der Folgendes aufweist: eine Resonanzschaltung, aus der er seine Versorgungsspannung aus einer durch einen Anschluss bestrahlten elektromagnetischen Schaltung extrahiert,
eine Pulsfolgenmodulationsschaltung mit mindestens einem Schalter (S), der die Last moduliert, die er auf dem elektromagnetischen Feld bildet, und
Mittel zur Steuerung des Duty- bzw. Tastverhältnisses der Impulse oder Pulse gemäß der Versorgungsspannung.

7. Transponder nach Anspruch 6, wobei die Steuermittel linear sind.

8. Transponder nach Anspruch 6, wobei die Steuermittel digital sind.

9. Transponder nach Anspruch 7 oder 8, wobei das Duty- bzw. Tastverhältnis konditioniert wird durch einen Vergleich der erwähnten Versorgungsspannung mit einer minimalen Spannung.

10. Transponder nach einem der Ansprüche 7 bis 9, wobei das Duty- bzw. Tastverhältnis konditioniert wird durch einen Vergleich der Versorgungsspannung mit einer Maximalspannung.
